# EUROPÄISCHE PATENTANMELDUNG

(11) **EP 2 048 691 A2**
(43) Veröffentlichungstag der Anmeldung: **15.04.2009**
(21) Anmeldenummer: 08016322.3
(22) Anmeldetag: 16.09.2008
(51) Int. Cl.: H01J 37/20, H01J 37/305, B23C 3/16, B29D 11/00, C03B 19/00

(54) **Vorrichtung zur Strahlbearbeitung von Werkstücken, Ionenstrahlbearbeitungsanlage**

(30) Priorität: 09.10.2007 DE 102007048559
(71) Anmelder: NTG Neue Technologien GmbH & Co. KG, 63571 Gelnhausen-Hailer (DE)
(72) Erfinder: Ritter, Gerhard, 63505 Langenselbold (DE)
(74) Vertreter: Müller, Eckhard

(57) **Zusammenfassung**

Die Erfindung betrifft eine Strahlbearbeitungsvorrichtung (2), insbesondere lonenstrahlbearbeitungsvorrichtung, zur Bearbeitung von Oberflächen von Werkstücken (4), insbesondere Linsen, (32). Die Werkstücke (4) werden in einer Werkstückhalterung (10) gehalten und mit einem Bearbeitungskopf (20), wobei im Bearbeitungszustand die Werkstückhalterung (10) entlang einer ersten Achse (Y) verfahrbar ist und der Bearbeitungskopf (20) entlang einer von der ersten Achse (Y) verschiedenen zweiten Achse (X) verfahrbar ist.

## Beschreibung

Die Erfindung betrifft eine Vorrichtung zur Strahlbearbeitung von Werkstücken. Die Werkstücke, insbesondere Linsen, werden in einer Werkstückhalterung gehalten und berührungslos mit einem Bearbeitungskopf, welcher insbesondere Ionenstrahlen abgibt, bearbeitet. Die Werkstückhalterung und der Bearbeitungskopf relativ zueinander verfahrbar sind.

### Stand der Technik

An die Präzision von Linsen werden immer höhere Anforderungen gestellt. Für hochpräzise Anwendungen sind Genauigkeiten bis in den Bereich von wenigen Nanometern erforderlich. Linsen wurden früher meist ausschließlich mechanisch poliert, die hiermit erzielbaren Genauigkeiten liegen jedoch weit unter den zuvor genannten Anforderungen.

Derartige Genauigkeiten lassen sich durch den Einsatz von lonenstrahl-Bearbeitungsanlagen, kurz IBF-Anlagen, erzielen, welche durch lonenbeschuss gezielt Material von den Linsen abtragen. Diese Bearbeitung wird als Sputtern bezeichnet. Die in einer IBF-Anlage zu bearbeitenden Linsen werden zuvor genau vermessen und festgestellt, an welcher Stelle der Linse wie viel Material abzutragen ist. Auf der Grundlage der Vermessungsdaten wird dann ein Bearbeitungsplan erstellt.

Im Stand der Technik sind Vorrichtungen nach dem Oberbegriff des Hauptanspruchs bekannt. Die Linse wird in einer Werkstückhalterung fest eingespannt und der Ionenstrahl emittierende Bearbeitungskopf bewegt sich zur Bearbeitung um die Linse herum. Eine Forderung an die Ausrichtungen des lonenstrahls zur Linse zur Sicherstellung höchstmöglicher Präzision ist dabei, dass die Ionenstrahlen senkrecht zur Oberfläche der zu bearbeitenden Werkstücke auftreffen.

Um diese Forderung umzusetzten, sind fünf Freiheitsgrade erforderlich, drei lineare Freiheitsgrade sowie zwei rotatorische Freiheitsgrade, um sowohl die Position als auch den Winkel des Ionenstrahles zur Linse einstellen zu können. Herkömmliche, aus dem Stand der Technik bekannte IBF-Anlagen sehen zur Umsetzung der fünf Freiheitsgrade einen Bearbeitungskopf auf, der auf einem Fünfachsensystems befestigt ist.

An die Positioniergenauigkeit des Bearbeitungskopfes zur Linse werden aufgrund der zu erzielenden Genauigkeiten höchste Anforderungen gestellt. Erschwerend kommt hinzu, dass dies nicht nur statisch, sondern dynamisch gilt. Die Abtragsrate hängt nämlich von der Strahlzeit ab und steigt darüber hinaus mit steigender Strahlzeit. Soll also in einem Bereich nur wenig Material abgetragen werden, muss die Bestrahlungszeit des betreffenden Bereiches auf der Linse besonders kurz ausfallen. Demnach muss der Bearbeitungskopf nicht nur äußerst genau positionierbar sein, sondern darüber hinaus für hohe Beschleunigungen ausgelegt sein, ohne dass die Positioniergenauigkeit an Präzision einbüßt. Im Resultat sind die Anforderungen an die Mechanik und Elektronik bei herkömmlichen IBF-Anlagen sehr hoch. Dies verteuert herkömmliche IBF-Anlagen daher.

Weiterhin sind beispielsweise in der Mikroskopie häufig kleine Linsen, beispielsweise solche mit einem Durchmesser von ca. 30 mm, zu bearbeiten, die am Rand stark gekrümmt sein können. Der Randwinkel derartiger Linsen beträgt durchaus 60° bis 90°. Dies erhöht die Anforderungen an die IBF-Anlagen bzw. den Bewegungsradius des Bearbeitungskopfes weiter, da dieser bei großen Randwinkeln einen sehr großen Schwenkbereich durchlaufen muss, was das erforderliche Beschleunigungsvermögen des Bearbeitungskopfes weiter erhöht und die Mechanik des Fünf-Achsen-Systems noch aufwändiger macht.

Bei herkömmlichen IBF-Anlagen besteht weiterhin das Problem, dass die Bestückung der Anlagen mit den zu bearbeitenden Linsen kompliziert ist. Die Linsen müssen an einer Werkstückhalterung befestigt oder auf einer Werkstückhalterung aufgebracht werden, was nur außerhalb der IBF-Anlage funktioniert. Die Werkstückhalterung wird mittels eines aufwändigen Wagensystems durch eine Schleuse in die Bearbeitungskammer geschleust. Die Bestückung der Werkstückhalterung lässt sich daher nur schwer automatisieren.

### Aufgabe

Aufgabe der Erfindung ist es, eine Vorrichtung zur Strahlbearbeitung von Oberflächen von Werkstücken anzugeben, die die Nachteile des Standes der Technik überwindet und die es insbesondere ermöglicht, eine preiswerte, dennoch robuste und präzise Vorrichtung bereitzustellen, mit der insbesondere kleine Linsen mittels lonenstrahlen bearbeitbar sind.

Eine weitere Aufgabe der Erfindung ist, eine derartige Vorrichtung anzugeben, die die Bearbeitung von Linsen zu einem stärkeren Grad als bisher automatisierbar macht.

### Darstellung der Erfindung

Die Aufgaben der Erfindung werden gelöst durch eine Vorrichtung gemäß dem unabhängigen Anspruch 1 sowie durch eine lonenstrahl-Bearbeitungsanlage gemäß dem nebengeordneten Anspruch 19.

Eine erfindungsgemäße Vorrichtung zur Strahlbearbeitung, insbesondere mittels Ionenstrahlen, von Oberflächen von Werkstücken, insbesondere von optischen Linsen, weist eine Werkstückhalterung und einen Bearbeitungskopf auf, wobei Werkstückhalterung und Bearbeitungskopf relativ zueinander verfahrbar sind. Der Begriff Bearbeitungskopf im erfindungsgemäßen Sinne umfasst sämtliche bekannten Ausgestaltungen von Strahlemittenden, die beweglich anordenbar sind.

Erfindungsgemäß ist vorgesehen, dass in einem Bearbeitungszustand der Vorrichtung, also bei in die Werkstückhalterung eingespannten Werkstücken und bei betriebsbereitem Bearbeitungskopf, die Werkstückhalterung entlang einer ersten Achse verfahrbar ist und der Bearbeitungskopf entlang einer von der ersten Achse verschiedenen zweiten Achse verfahrbar ist.

Der Erfindung liegt somit der Gedanke zugrunde, dass die erforderlichen Freiheitsgrade nicht von dem Bearbeitungskopf alleine bereitgestellt werden müssen, sondern dass die Freiheitsgrade auf den Bearbeitungskopf und auf die Werkstückhalterung verteilt werden können. Besonders vorteilhaft an der erfindungsgemäßen Verteilung wenigstens eines Freiheitsgrades auf die Werkstückhalterung ist, dass diese verglichen mit dem Bearbeitungskopf vergleichsweise leicht und damit wenig träge ist. So ist es möglich, die Werkstückhalterung mit einem geringeren konstruktiven Aufwand so auszulegen, dass sie sehr präzise beschleunig- und positionierbar ist.

Nach einer ersten vorteilhaften Ausgestaltung ist vorgesehen, dass die Werkstückhalterung entlang einer von der ersten und der zweiten Achse verschiedenen dritten Achse verfahrbar ist. Die erste Achse bildet somit eine Längsachse, die zweite Achse eine Quer- oder Zustellachse und die dritte Achse eine Hochachse.

Alternativ kann vorgesehen sein, dass der Bearbeitungskopf entlang einer von der ersten und von der zweiten Achse verschiedenen dritten Achse verfahrbar ist. Dies hat den weiteren Vorteil, dass die Werkstückhalterung noch leichter ausgelegt werden kann, was die Trägheit der Werkstückhalterung verringert.

Die zu bearbeitenden Werkstücke, insbesondere Linsen, werden mit der erfindungsgemäßen Vorrichtung bevorzugt zeilenweise bearbeitet, wobei die Zeilen in Richtung der ersten Achse, also der, in der die Werkstückhalterung beweglich ausgestaltet ist, ausgerichtet sind. Durch die zweite Achse des Bearbeitungskopfes werden ggf. Zustellbewegungen zur Linse vorgenommen. Nach Bearbeitung einer vollständigen Zeile, während der der Bearbeitungskopf seine Position nur über kurze Distanzen als Zustellbewegung entlang der zweiten Achse bewegt wird, wird der Bearbeitungskopf entlang der dritten Achse ein Stück relativ zu der Linse verschoben. Eine Verstellung entlang der zweiten und der dritten Achse ist jedoch nicht mit so hohen Beschleunigungen erforderlich, wie eine Verstellung entlang der ersten Achse.

Nach einer ersten vorteilhaften Ausgestaltung der Erfindung ist die Werkstückhalterung um eine erste Schwenkachse schwenkbar ausgestaltet. Damit lässt sich der Winkel des Werkstücks, insbesondere der Linse, relativ zu dem Bearbeitungskopf einstellen. Die Werkstückhalterung ist gemäß dieser Ausgestaltung entlang einer ersten Achse verfahrbar und um die erste Schwenkachse schwenkbar. Der bevorzugte Schwenkbereich der Werkstückhalterung für die Bearbeitung, bei der eine sehr hohe Präzision erforderlich ist, liegt zwischen 90° und 180°, insbesondere zwischen 110° und 140°, wobei insbesondere 120° bevorzugt sind. Der Schwenkbereich ist vorzugsweise symmetrisch zur zweiten Achse angeordnet. Damit lassen sich Linsen mit Randwinkeln von 45° bis 90° bearbeiten, in der bevorzugten Ausführung zwischen 55° und 70° und in der besonders bevorzugten Ausführung mit 120°.

Weiterhin ist es vorteilhaft, wenn der Bearbeitungskopf um eine zweite Schwenkachse schwenkbar ist. Damit lässt sich der Bearbeitungskopf stets senkrecht zu einer Flächennormale des zu bearbeitenden Werkstückes ausrichten, sodass das Erfordernis, dass der Ionenstrahl senkrecht auf das zu bearbeitende Werkstück auftreffen soll, besonders einfach umsetzen lässt. Bevorzugt ist der Schwenkbereich des Bearbeitungskopfes genau so ausgestaltet wie der zuvor beschriebene Schwenkbereich der Werkstückhalterung, um rotationssymmetrische Linsen mit Randwinkeln von mehr als 45°, bevorzugt 60°, bearbeiten zu können.

In einer besonders vorteilhaften Ausgestaltung sind die drei linearen Achsen paarweise senkrecht zueinander angeordnet, sodass diese einen kartesischen Raum aufspannen. Dies ermöglicht einerseits eine besonders kompakte Konstruktion der Bearbeitungsvorrichtung und andererseits eine besonders einfach zu realisierende Steuerung der Vorrichtung.

Nach einer weiteren vorteilhaften Ausgestaltung ist die Schwenkachse der Werkstückhalterung im Wesentlichen parallel zu der dritten Achse ausgerichtet. Besonders bevorzugt ist, die Schwenkachse der Werkstückhalterung exakt parallel zur dritten Achse auszurichten. Damit lässt sich eine zeilenweise Bearbeitung der zu bearbeitenden Werkstücke besonders leicht verwirklichen.

Weiterhin kann es mit besonderem Vorteil vorgesehen sein, dass die Schwenkachse des Bearbeitungskopfes im Wesentlichen, bevorzugt exakt, parallel zur ersten Achse der Werkstückhalterung ausgerichtet ist. Dies erleichtert das Einstellen des passenden Winkels, abhängig von der zu bearbeitenden Zeile.

Nach einer besonders bevorzugten Ausgestaltung ist die Werkstückhalterung auf einem entlang der ersten Achse verfahrbaren ersten Schlitten angeordnet. Der Schlitten kann so ausgestaltet sein, dass er einen Träger der Werkstückhalterung bildet oder auf dem Schlitten kann ein Träger angeordnet sein. Die Werkstückhalterung selbst ist dann bevorzugt mittels einer Drehvorrichtung an dem Schlitten bzw. Träger befestigt.

Weiterhin ist es vorteilhaft, wenn der Bearbeitungskopf ebenfalls auf einem Schlitten angeordnet ist, welcher entlang der zweiten Achse verfahrbar ist. Der Schlitten kann so ausgestaltet sein, dass er einen Träger des Bearbeitungskopfes bildet oder auf dem Schlitten kann ein Träger angeordnet sein.

Besonders bevorzugt ist bei der letzgenannten vorteilhaften Ausgestaltung vorgesehen, dass an dem zweiten Schlitten ein in Richtung der dritten Achse verstellbarer dritter Schlitten angeordnet ist. Damit lassen sich auf besonders einfache Weise die drei erforderlichen Linearbewegungen verwirklichen. Schlitten lassen sich mit geringen Toleranzen und sehr exakt positionieren und beschleunigen und auch die Kombination zweier Schlitten aneinander ist ohne Probleme realisierbar.

Besonders bevorzugt ist, wenn der Schlitten der Werkstückhalterung und der Schlitten des Bearbeitungskopfes auf einer gemeinsamen Basis angeordnet sind. Dies vereinfacht die Konstruktion und erlaubt ein genaues Positionieren und Kalibrieren der Vorrichtung.

Nach einer besonders vorteilhaften Ausgestaltung ist eine Schleuse für die Werkstücke vorgesehen, die so ausgerichtet ist, dass eine Schleusenöffnung eine durch die erste Achse und einem Drehzentrum der Werkstückhalterung gebildeten Ebene schneidet. Die erste Achse soll dabei gedanklich im Bereich des Schlittens angeordnet sein, wodurch die Ebene parallel zu einer durch die Bewegung des Werkstückhalters gebildete Ebene ist. Sofern sämtliche linearen Achsen orthogonal aufeinander stehen, ist die zuvor beschriebene Ebene weiterhin parallel zu einer durch die erste und die dritte Achse gebildeten Ebene.

Damit wird erreicht, dass die Werkstückhalterung Werkstücke aus der Schleuse heraus greifen kann und fertig bearbeitete Werkstücke in die Schleuse zurück übergeben kann. Durch eine derartige Anordnung wird also die erfindungsgemäße Beweglichkeit der Werkstückhalterung gleichzeitig zur Beschickung der Anlage mit Werkstücken benutzt. Die Schleuse kann somit sehr klein ausfallen, wodurch das im Inneren der Vorrichtung meist erforderliche Vakuum nicht sonderlich beeinflusst wird. Dadurch ist ein größerer Grad an Automatisierung, kürzere Betriebszeiten und damit verbunden ein höherer Durchsatz erzielbar.

Besonders bevorzugt ist, wenn die Schleusenöffnung auf der Höhe der Werkstückhalterung angeordnet ist.

Nach einer weiteren vorteilhaften Ausgestaltung der Erfindung ist vorgesehen, dass die Werkstückhalterung eine Greif- und Positioniervorrichtung zum Greifen und Positionieren der Werkstücke aufweist. Dies ermöglicht eine exakte Positionierung der Werkstücke in der Werkstückhalterung.

In einer besonders bevorzugten Ausgestaltung ist der Bearbeitungskopf als Ionenstrahl-Bearbeitungskopf ausgestaltet.

Nach einer weiteren vorteilhaften Ausgestaltung sind die zu bearbeitenden Werkstücke Linsen. Die Linsen haben bevorzugt einen Durchmesser von 2 mm bis 150 mm, bevorzugt 3 mm bis 100 mm, bevorzugt 5 mm bis 50 mm, bevorzugt 25 mm bis 35 mm, insbesondere bevorzugt 30 mm. Dabei können die Linsen einen Randwinkel von 0° bis 90°, bevorzugt 30° bis 90°, bevorzugt 30° bis 75°, besonders bevorzugt 60°, aufweisen. Dabei gilt bevorzugt, dass je flacher der Randwinkel, desto größer die Linse. Bei ebenen Oberflächen können sehr große Linsen bearbeitet werden, z.B. von 100 mm.

Ein weiterer unabhängiger Gedanke der Erfindung betrifft eine lonenstrahl-Bearbeitungsanlage mit einer Vorrichtung gemäß der zuvor beschriebenen Erfindung.

Weitere Ziele, Vorteile, Merkmale und Anwendungsmöglichkeiten der vorliegenden Erfindung ergeben sich aus der nachfolgenden Beschreibung eines 30 Ausführungsbeispieles anhand der Zeichnung. Dabei bilden alle beschriebenen und/oder bildlich dargestellten Merkmale für sich oder in beliebiger sinnvoller Kombination den Gegenstand der vorliegenden Erfindung, auch unabhängig von ihrer Zusammenfassung in den Ansprüchen oder deren Rückbeziehung.

Es zeigen:
- Figur 1: eine schematische dreidimensionale Ansicht einer erfindungsgemäßen Bearbeitungsvorrichtung;
- Figur 2: die Vorrichtung aus Figur 1 ohne dargestellte Schleuse in einer Entnahmeposition und
- Figur 3: die Vorrichtung aus Figur 1 ohne dargestellte Schleuse in einer Bearbeitungsposition.

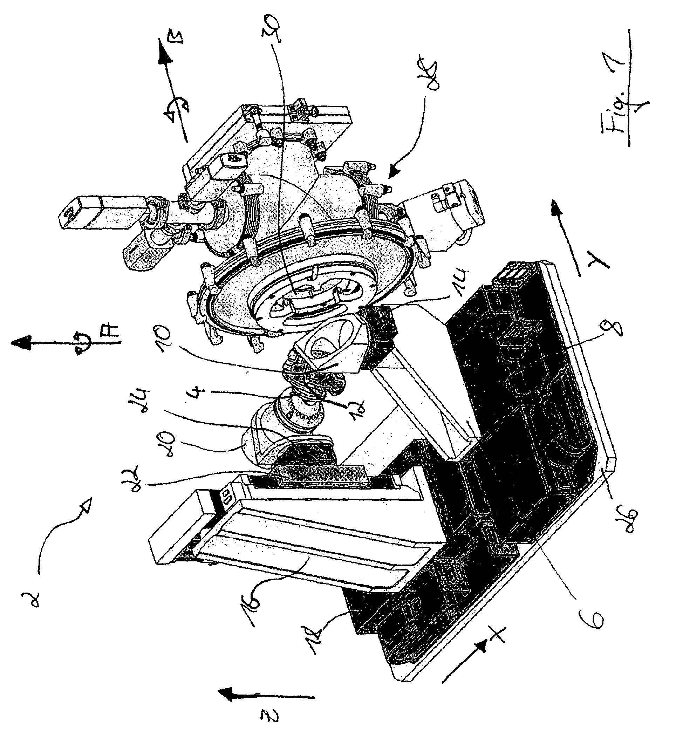

Die Figuren 1 bis 3 zeigen ein bevorzugtes Ausführungsbeispiel der Erfindung. Das Ausführungsbeispiel stellt eine IBF-Anlage 2 zur Bearbeitung von optischen Linsen 4 mittels lonenstrahlen dar. Unter anderem nicht dargestellt sind ein die Bearbeitungsvorrichtung umgebendes Vakuumgehäuse, das notwendig ist, um ein Vakuum im Bearbeitungsraum zu erzeugen und um Schmutz von dem Bearbeitungsraum fernzuhalten sowie eine Steuerungsvorrichtung und ggf. eine Vermessungsvorrichtung.

Die erfindungsgemäße Bearbeitungsvorrichtung 2 weist einen ersten Träger 6 auf, der auf einem ersten Schlitten 8 angeordnet ist. Auf dem ersten Träger 6 ist eine Werkstückhalterung 10 für die Linse 4 vorgesehen, die eine teilweise verdeckte Greif- und Positioniervorrichtung 12 für die Linse 4 aufweist. Der erste Schlitten 8 ist in Y-Richtung verfahrbar.

Die Werkstückhalterung 10 ist mittels eines ersten Motors 14 drehbar auf dem ersten Träger 6 befestigt. Die Werkstückhalterung 10 ist um eine Schwenkachse A schwenkbar, die parallel zur dritten Achse Z ist.

Ein zweiter Träger 16 zur Halterung eines Bearbeitungskopfes 20 ist auf einem zweiten Schlitten 18 angeordnet. Der zweite Schlitten 18 ist in X-Richtung verfahrbar. Mittels des zweiten Schlittens 18 kann der Bearbeitungskopf 20 auf die Linse 4 zu- und von der Linse 4 weggestellt werden.

Der Bearbeitungskopf 20 selbst ist an einem dritten Schlitten 22 befestigt, welcher den Bearbeitungskopf 20 in Z-Richtung verfahren kann. Mittels eines zweiten Motors 24 ist die Bearbeitungseinheit entlang einer Schwenkachse B schwenkbar.

Die Schwenkachse B ist im bevorzugten Ausführungsbeispiel parallel zur ersten Achse Y, entlang derer die Werkstückhalterung 10 verstellbar ist.

Der erste Schlitten 8 und der zweite Schlitten 18 sind auf einer gemeinsamen Basis 26 angeordnet, um die Positionen von Bearbeitungskopf 20 und Werkstückhalterung 10 relativ zueinander besonders exakt festlegen zu können und um die Bearbeitungsvorrichtung 2 besonders leicht kalibrieren zu können. Darüber hinaus verleiht die gemeinsame Basis 26 eine besondere Stabilität. Die gemeinsame Basis 26 kann auch als Gehäuseboden des die Bearbeitungsvorrichtung umgebenden Vakuumgehäuses ausgebildet sein.

Ein weiterer Bestandteil der bevorzugten Ausführungsform, der jedoch nicht in sämtlichen Ausführungsformen der Erfindung vorhanden sein muss, ist eine Schleuse 28. Die Schleuse 28 dient zum Einführen von zu bearbeitenden Linsen 4 bzw. zur Ausgabe von bearbeiteten Linsen. Die Schleuse 28 gewährleistet dabei die Aufrechterhaltung des Vakuums in der nicht dargestellten Bearbeitungskammer und verhindert weiterhin das Eindringen von Schmutzpartikeln in den Bearbeitungsraum.

Zur Werkstückhalterung 10 hin ist eine Schleusenöffnung 30 vorgesehen, die so angeordnet ist, dass die Werkstückhalterung 10 Linsen 4 aus der Schleuse 28 heraus greifen kann und nach der Bearbeitung in die Schleuse 28 hinein geben kann. Dazu ist die Schleusenöffnung 30 in X- und in Z-Richtung so angeordnet, dass durch eine Zustellbewegung des ersten Schlittens 8 der Werkstückhalterung 10 auf die Schleusenöffnung 30 mit entsprechend gedrehter Werkstückhalterung in die Schleusenöffnung 30 hineingreifen kann.

Eine Bearbeitung einer Linse 4 mit der erfindungsgemäßen Bearbeitungsvorrichtung erfolgt wie folgt:

Die Linse 4 wird zunächst vermessen und aus den Vermessungsdaten, insbesondere aus den Abweichungen der Ist-Geometrie von der Soll-Geometrie, wurde ein Bearbeitungsplan errechnet, der bestimmt, wie viel Material von welcher Stelle der Linse abgetragen wird und wie lange der lonenstrahl hierzu auf welcher Stelle der Linse verweilen muss. Der Weg des lonenstrahls auf der Linse wird mäanderartig festgelegt, also eine zeilenweise Bearbeitung der Linse 4, wobei untereinander liegende Zeilen in abwechselnden Richtungen bearbeitet werden.

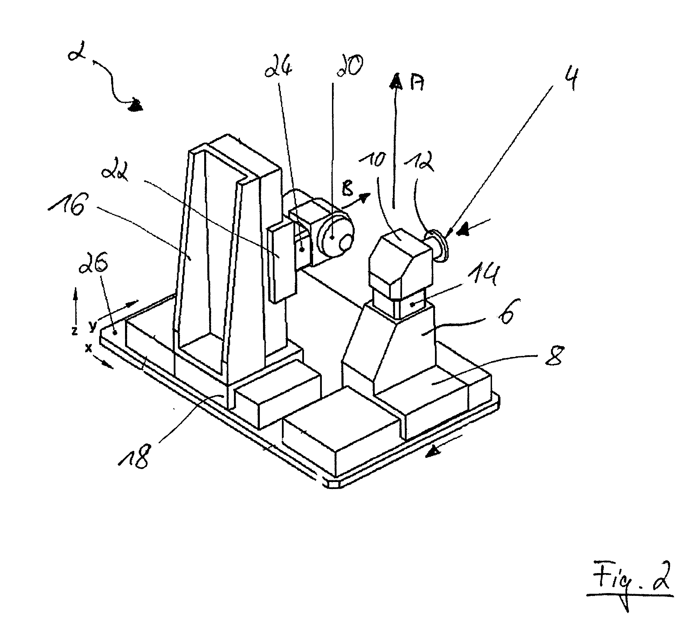

Anschließend wird, wie in Figur 2 dargestellt, die zuvor vermessene Linse 4 aus der in Figur 2 nicht dargestellten Schleuse 28 mit der Greifvorrichtung 12 in einer eindeutigen Position gegriffen und der erste Schlitten 8 von der Schleuse 28 weg bewegt. Dann wird die Werkstückhalterung 10 mittels des ersten Motors 14 so gedreht, dass die Linse 4 dem Bearbeitungskopf 20 zugewandt ist. Anschließend wird der Bearbeitungskopf 20 durch Verfahren der Schlitten 18 und 22 sowie durch Schwenken mittels des zweiten Motors 24 in die passende Position gebracht.

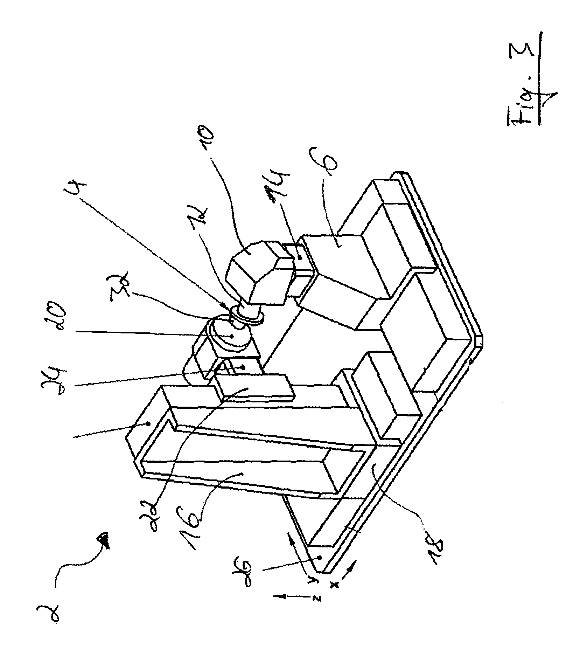

Die Werkstückhalterung 10 wird dabei um die Achse A und der Bearbeitungskopf 20 um die Achse B derart gedreht, dass ein in Fig. 3 dargestellter, aus dem Bearbeitungskopf 20 austretender lonenstrahl 32 stets senkrecht auf die Oberfläche der zu bearbeitenden Linse 4 trifft.

Die Zeilen werden durch eine Verstellung der Werkstückhalterung in Y-Richtung erzeugt, wobei die Geschwindigkeit, mit welcher der Schlitten 8 und damit die Werkstückhalterung 10 bewegt wird, von dem abzutragenden Material abhängt. Gleichzeitig wird beim Bewegen der Linse 4 relativ zu dem Bearbeitungskopf 20 die Werkstückhalterung 10 mittels des ersten Motors 14 derart geschwenkt, dass der Ionenstrahl stets senkrecht auf die Linse auftrifft. Mittels des Schlittens 18 wird der Bearbeitungskopf 20 gleichzeitig in gleichbleibender Entfernung zu dem zu bearbeitenden Bereich der Linse 4 positioniert.

Nachdem eine Zeile abgearbeitet wurde, wird der Bearbeitungskopf in seiner Höhe mittels des Schlittens 22 verstellt und mittels des zweiten Motors 24 in seiner Neigung der Oberfläche der Linse 4 angepasst.

Nach dem Bearbeiten der Linse 4 wird diese wieder durch die Schleuse 28 ausgegeben.

### Bezugszeichenliste

- 2: Bearbeitungsvorrichtung
- 4: Linse
- 6: Erster Träger
- 8: Erster Schlitten (Y)
- 10: Werkstückhalterung
- 12: Greif- und Positioniervorrichtung
- 14: Erster Motor
- 16: Zweiter Träger
- 18: Zweiter Schlitten (X)
- 20: Bearbeitungskopf
- 22: Dritter Schlitten (Z)
- 24: Zweiter Motor
- 26: Basis
- 28: Schleuse
- 30: Schleusenöffnung
- 32: lonenstrahl

- Y: Erste Achse
- X: Zweite Achse
- Z: Dritte Achse
- A: Schwenkachse der Werkstückhalterung
- B: Schwenkachse des Bearbeitungskopfes

## Patentansprüche

1. Vorrichtung zur Strahlbearbeitung, insbesondere mit lonenstrahlen, von Oberflächen von Werkstücken (4), insbesondere Linsen, mit einer Werkstückhalterung (10) und mit einem Bearbeitungskopf (20), wobei Werkstückhalterung (10) und Bearbeitungskopf (20) relativ zueinander verfahrbar sind, wobei im Bearbeitungszustand die Werkstückhalterung (10) entlang einer ersten Achse (Y) verfahrbar ist und der Bearbeitungskopf (20) entlang einer von der ersten Achse (Y) verschiedenen zweiten Achse (X) verfahrbar ist, **dadurch gekennzeichnet, dass** die Werkstückhalterung (10) um eine erste Schwenkachse (A) schwenkbar ist.

2. Vorrichtung nach Anspruch 1, **dadurch gekennzeichnet, dass** die Werkstückhalterung (10) oder der Bearbeitungskopf entlang einer von der ersten Achse (Y) und von der zweiten Achse (X) verschiedenen dritten Achse (Z) verfahrbar ist.

3. Vorrichtung nach einem der vorangegangenen Ansprüche, **dadurch gekennzeichnet, dass** der Bearbeitungskopf (20) um eine zweite Schwenkachse (B) schwenkbar ist.

4. Vorrichtung nach einem der Ansprüche 1 bis 3, **dadurch gekennzeichnet, dass** der Schwenkbereich der Werkstückhalterung (10) und/oder des Bearbeitungskopfes (20) 90° bis 180°, bevorzugt 110° bis 140°, bevorzugt 120°, beträgt.

5. Vorrichtung nach einem der Ansprüche 2 bis 4, **dadurch gekennzeichnet, dass** die erste, zweite und dritte Achse (Y, X, Z) paarweise senkrecht zueinander stehen.

6. Vorrichtung nach einem der vorangegangen Ansprüche, **dadurch gekennzeichnet, dass** die erste Schwenkachse (A) der Werkstückhalterung (10) im wesentlichen, bevorzugt exakt, parallel zur dritten Achse (Z) und/oder dass die zweite Schwenkachse (B) des Bearbeitungskopfes (20) im wesentlichen, bevorzugt exakt, parallel zur ersten Achse (Y) ausgerichtet ist.

7. Vorrichtung nach einem der vorangegangenen Ansprüche, **dadurch gekennzeichnet, dass** die Werkstückhalterung (10) auf einem entlang der ersten Achse (Y) verfahrbaren ersten Schlitten (8) und/oder dass der Bearbeitungskopf (20) auf einem entlang der zweiten Achse (X) verfahrbaren zweiten Schlitten (18) angeordnet ist.

8. Vorrichtung nach Anspruch 7, **dadurch gekennzeichnet, dass** an dem zweiten Schlitten (18) ein in Richtung der dritten Achse (Z) verstellbarer dritter Schlitten (22) angeordnet ist.

9. Vorrichtung nach einem der Ansprüche 7 oder 8, **dadurch gekennzeichnet, dass** der erste Schlitten (8) und der zweite Schlitten (18) auf einer gemeinsamen Basis (26) angeordnet sind.

10. Vorrichtung nach einem der vorangegangenen Ansprüche, **dadurch gekennzeichnet, dass** eine Schleuse (28) für die Werkstücke (4) vorgesehen ist, wobei eine durch die erste Achse (Y) und einem Drehzentrum der Werkstückhalterung (10) gebildete Ebene eine Schleusenöffnung (30) der Schleuse (28) schneidet.

11. Vorrichtung nach einem der vorangegangenen Ansprüche, **dadurch gekennzeichnet, dass** die Werkstückhalterung (10) eine Greif- und Positioniervorrichtung (12) zum Greifen der Werkstücke (4) aufweist.

12. Vorrichtung nach einem der vorangegangenen Ansprüche, dass der Bearbeitungskopf (20) Ionenstrahlen (32) abgibt.

13. Vorrichtung nach einem der vorangegangenen Ansprüche, **dadurch gekennzeichnet, dass** die zu bearbeitenden Werkstücke Linsen (4) sind.

14. Vorrichtung nach Anspruch 13, **dadurch gekennzeichnet, dass** die Linsen (4) einen Durchmesser von 2 mm bis 150 mm, bevorzugt 3 mm bis 100 mm, bevorzugt 5 mm bis 50 mm, bevorzugt 25 mm bis 35 mm, insbesondere bevorzugt 30 mm, haben und/oder einen Randwinkel von 30° bis 90°, bevorzugt 30° bis 75°, besonders bevorzugt 60°, aufweisen.

15. Ionenstrahlbearbeitungsanlage mit einer Vorrichtung (2) nach einem der vorangegangenen Ansprüche.
